(19) Europäisches Patentamt
European Patent Office
Office européen des brevets

(11) **EP 2 593 799 B1**

(12) # EUROPEAN PATENT SPECIFICATION

(45) Date of publication and mention
of the grant of the patent:
**24.02.2021 Bulletin 2021/08**

(21) Application number: **11717539.8**

(22) Date of filing: **20.04.2011**

(51) Int Cl.:
**G01R 15/18** *(2006.01)*   **G01R 19/20** *(2006.01)*

(86) International application number:
**PCT/EP2011/056342**

(87) International publication number:
**WO 2012/007195 (19.01.2012 Gazette 2012/03)**

(54) **CURRENT MEASUREMENT APPARATUS AND CURRENT MEASUREMENT METHOD THEREOF**

STROMMESSGERÄT UND VERFAHREN ZUR STROMMESSUNG DAFÜR

APPAREIL DE MESURE DE COURANT ET PROCÉDÉ DE MESURE DE COURANT ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.07.2010   CN 201010230155**

(43) Date of publication of application:
**22.05.2013   Bulletin 2013/21**

(73) Proprietor: **Siemens Aktiengesellschaft
80333 München (DE)**

(72) Inventors:
• **MIN, Ying Zong
Shanghai 200129 (CN)**

• **DANKERT, Mario
06779 Raguhn-Jeßnitz (DE)**
• **DU, Feng
Shanghai 200030 (CN)**
• **CHEN, Wei Gang
200082 Shanghai (CN)**
• **ZHUO, Yue
Beijing 100084 (CN)**

(74) Representative: **Patentanwaltskanzlei WILHELM
& BECK
Prinzenstraße 13
80639 München (DE)**

(56) References cited:
**EP-B1- 1 212 821       EP-B1- 1 610 133
US-A1- 2009 315 536    US-B1- 6 984 979**

## Description

## Technical field

The present invention relates to a current measurement apparatus and a current measurement method thereof and, particularly to a current measurement apparatus and a current measurement method thereof based on the principle of magnetic modulation, which are especially suitable for the measurement of B class residual current of an AC and/or DC current.

## Background art

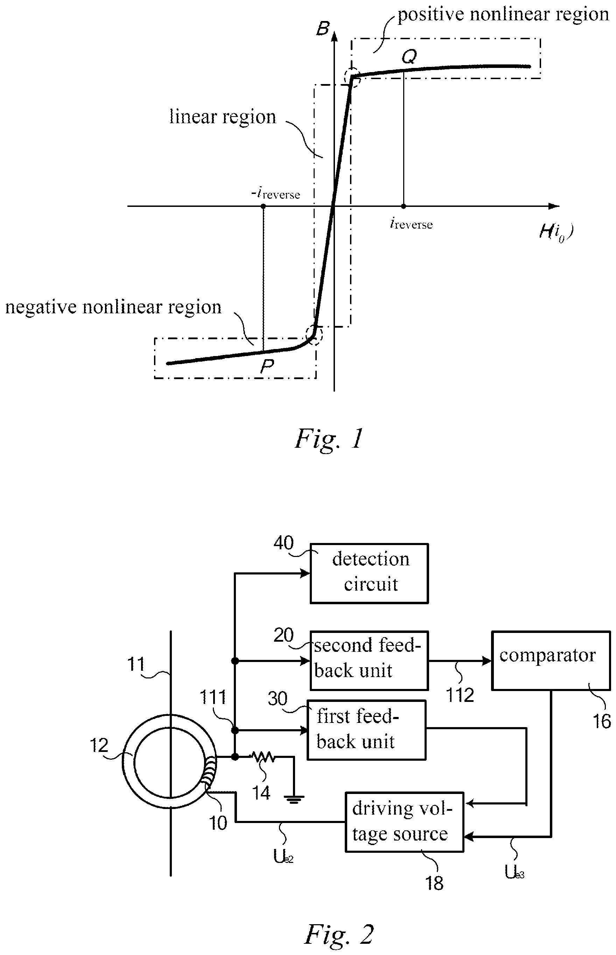

AC and/or DC testing methods based on magnetic modulation technology have been applied widely, in which the operating state of a magnetic core is put alternatively into the linear and nonlinear regions of a magnetic core magnetization curve (also referred to as hysteresis curve, BH curve, and referred to as BH curve herein below) as shown in Fig. 1 by way of a driving voltage source, and here it is very important to judge the intersection points of the linear region and the nonlinear regions in BH curve (as shown by the dashed circles in the figure), and this is helpful to reverse the output voltage of the driving voltage source at a position close to the above-mentioned intersection in a nonlinear region.

US 6,984,979 B1 describes an apparatus for measuring a magnetomotive force experienced by a magnetic body. For avoiding a saturation of the magnetic body, non-linearities in core permeability below saturation levels are utilized for detection of a bias of a magnetic field caused by the magnetomotive force. The non-linearities are utilized by detecting a second harmonic of the magnetomotive force.

US 2009/0315536 A1 describes a compensation current sensor, wherein a secondary current signal is sampled during a remagnetization process.

European patent EP1212821 discloses an AC and/or DC current measurement apparatus based on magnetic modulation. In particular, a measured signal is modulated by an AC voltage driving signal generated by a driving voltage source, and since there is no relationship between the generation of the AC voltage driving signal and the measured signal, it is very difficult to control the operating state of the magnetic core. A limitation caused by this solution is that the material of selected magnetic core is required to have very good consistency, which results in relatively high costs for magnetic core material and processing and manufacturing thereof. Another limitation caused by this solution is that the magnetic core may be set in an over-saturation state, so it may result in relatively high power consumption.

European patent EP1610133 discloses another AC and/or DC current measurement apparatus based on magnetic modulation. In this solution, a sampling resistor is serially connected to a coil, and when the voltage signal on this sampling resistor is higher than a preset value, the voltage driving source is reversed. Since the generation of AC voltage driving signal introduces a feedback signal, it reduces the consistency requirements of the magnetic core material. However, this solution also has limitations, since the feedback signal cannot precisely reflect the change in the coil's inductance; when the current to be measured changes, the reverse turning point of the magnetic core will also change, and this may influence the accuracy of current measurement. In order to increase the current detection range and avoid the possibility of the turning point entering the linear region, this turning point has to be set as far away from the intersection of the linear region and the nonlinear region as possible, but this would result in relatively high power consumption. At the same time, this solution needs an amplifier apparatus connected to the input end of the sampling resistor, which increases the circuit complexity.

## Contents of the invention

An object of the present invention is to provide a current measurement apparatus, which apparatus is capable of locating the output voltage reverse control point of a driving voltage source set in the nonlinear region of the magnetic ring's BH curve as close to the real intersection of the nonlinear region and the linear region as possible, so as to extend the measurement range of the current to be measured, improve the measurement accuracy, and at the same time reduce the power consumption of the measurement apparatus during a test.

The present invention further provides a current measurement method, which method is capable of locating the output voltage reverse control point of the driving voltage source set in the nonlinear region of the magnetic ring's BH curve as close to the real intersection of the nonlinear region and the linear region as possible, thereby it can extend the measurement range of the current to be measured, improve the measurement accuracy, and at the same time reduce the power consumption of the measurement apparatus during a test.

The object is met by the independent claims.

The present invention provides an apparatus for current measurement, comprising: a magnetic ring, through which can pass at least one conductor for passing a current to be measured; a coil wound around said magnetic ring; a sampling resistor, that produces a first feedback signal, which may be a voltage signal, wherein a first end of the sampling resistor is electrically connected to a first end of said coil, so that the sampling resistor is connected in series with said coil and a second end of the sampling resistor is connected to earth; a driving voltage source, with an output end thereof being electrically connected to another end of said coil, the driving voltage source having an adder; a comparator, with an output end thereof being electrically connected to a first input end of said driving voltage source being a first input end of the adder; a first feedback unit, wherein an input end of said first feedback unit is connected to the end of said sampling resistor, which is connected at the first end of said coil, for acquiring the first feedback signal from said sampling resistor, wherein an output end of the first feedback unit is electrically connected to another input end of said adder for providing the first feedback signal to said driving voltage source. The apparatus further comprises a second feedback unit having a differentiator, wherein an input of said second feedback unit is connected to the end of said sampling resistor, which is connected at the first end of said coil, to acquire the first feedback signal from said sampling resistor to process the first feedback signal by a differentiator and to generate a second feedback signal, wherein an output end of said second feedback unit is connected to an input end of said comparator, wherein a first preset value is set in said comparator, and the first preset value controls the output polarity of said driving voltage source, such that the reverse point of the output polarity of said driving voltage source is set in a saturation region of said magnetic ring.

In the current measurement apparatus, a first preset value is set in the comparator, and the first preset value controls the polarity of said driving voltage to cause the polarity reverse point of the driving voltage to be set in a saturation region in which said magnetic ring operates. A second preset value may be also set in the comparator, wherein the second preset value controls the output polarity of said driving voltage source, and said second preset value is used to prevent said driving voltage ($U_{e2}$) from being reversed in the remaining time domain, except the one where the first preset value was used.

In the current measurement apparatus, the output voltage ($U_{e3}$) of the comparator is a square wave voltage with a fixed amplitude.

The current measurement apparatus also comprises a detection circuit to acquire the first feedback signal from the sampling resistor to obtain a current signal i measured thereby.

The present invention further provides a method for current measurement as in claim 2.

When using the current measurement apparatus and the current measurement method of the present invention, the amplitude of the driving voltage is controlled by the voltage signal over the sampling resistor so as to control the magnitude of the drive current, and the operating state of magnetic core has no relationship with the current to be measured, therefore, for the current to be measured, there is a relatively wide range of current measurement.

When using the current measurement apparatus and the current measurement method of the present invention, since the operating time of magnetic core under saturation is reduced, the power consumption during measurement can be effectively reduced.

Furthermore, since the reverse control point of the driving voltage is set in the nonlinear region close to the real intersection of the linear region and the nonlinear region of magnetic core's BH curve, and this reverse control point has no relationship with the current to be measured, therefore, the measurement apparatus and method of the present invention have relatively high measurement accuracy.

Moreover, since the reverse control point of the polarity of the driving voltage is set in the nonlinear region of the magnetic core's BH curve, automatic magnetic reset can be achieved by employing the current measurement apparatus and method of the present invention.

**Description of the accompanying drawings**

Fig. 1 is an illustrative diagram of the BH curve of a magnetic ring.
Fig. 2 is an illustrative diagram of the circuit structure of an illustrative embodiment of a current measurement apparatus of the present invention.
Fig. 3 is an illustrative diagram of the circuit structure of a particular illustrative embodiment of the current measurement apparatus in Fig. 2.
Fig. 4 is an equivalent circuit of the circuit in Fig. 2.
Fig. 5 is an illustrative diagram of the timing relationship in the circuit shown in Fig. 2.

Description of reference numerals

10 coil 11 conductor 12 magnetic ring 14 sampling resistor
16 comparator 18 driving voltage source 20 second feedback unit
30 first feedback unit 40 detection circuit

**Particular embodiments**

For the sake of better understanding the technical features, objects and effects of the present invention, particular embodiments of the present invention will now be described by reference to the accompanying drawings, and in the drawings like numerals refer to components with the same structure or with similar structure but the same function.

Fig. 2 is an illustrative embodiment of a current measurement apparatus of the present invention, which apparatus comprises a magnetic ring 12, a coil 10, a sampling resistor 14, a driving voltage source 18, a comparator 16, a first feedback unit 30 and a second feedback unit 20.

A conductor 11, through which a current (DC or AC) to be measured can pass, passes through the magnetic ring 12, the coil 10 is wound around the magnetic ring 12, the sampling resistor 14 is serially connected to an end of the coil 10, another end of the coil 10 is electrically connectable to an output end of the driving voltage source 18, and the driving voltage source 18 outputs a driving voltage $U_{e2}$ and generates a drive current i in the sampling resistor 14 and the coil 10. The output voltage at the output end of the comparator 16 is $U_{e3}$, which is electrically connectable to an input end of the driving voltage source 18.

In the current measurement apparatus, the first feedback unit 30 acquires a first feedback signal 111 from the sampling resistor 14, in the illustrative embodiment shown in fig. 2, the first feedback signal 111 is a voltage signal, i.e. iR, and the first feedback signal 111 is inputted into an input end of the driving voltage source 18.

The second feedback unit 20 can also acquire the first feedback signal 111, in the illustrative embodiment shown in fig. 2, the first feedback signal 111 is a voltage signal, i.e. iR, and the second feedback unit 20 generates a second feedback signal 112, i.e. the differential signal of the drive current i, after having the current signal therein processed differentially, and then the second feedback signal 112 is inputted into an input end of the comparator 16. The second feedback unit 20 is used to control the polarity of the driving voltage $U_{e2}$ outputted by the driving voltage source 18, while the first feedback unit 30 and the second feedback unit 20 are overlapped to control the output voltage signal of the driving voltage $U_{e2}$ outputted by the driving voltage source 18.

Those skilled in the art would understand that the second feedback unit can achieve the differentiation of the drive current i by a differentiator.

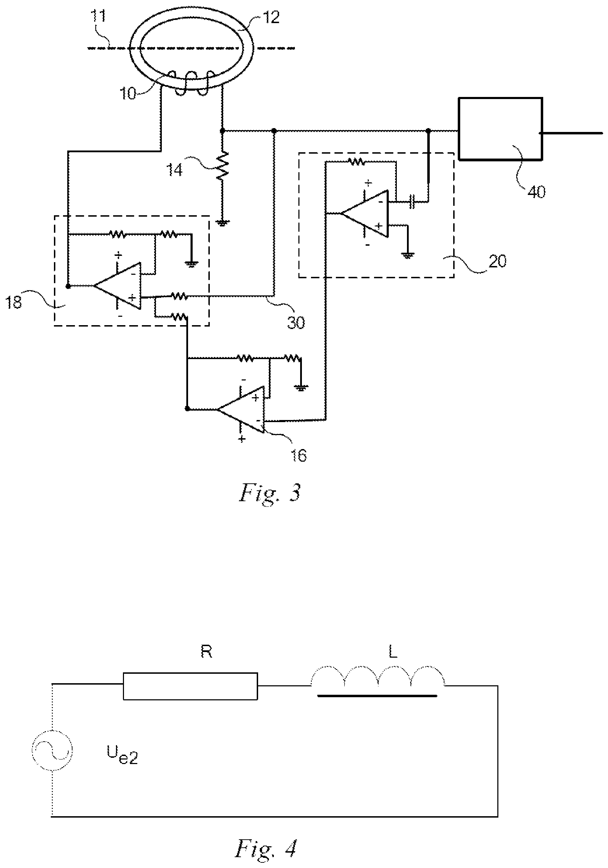

Fig. 3 is an illustrative diagram of the circuit structure of a particular illustrative embodiment of the current measurement apparatus in fig. 2. It includes a magnetic ring 12, a coil 10, a sampling resistor 14, a driving voltage source 18, a comparator 16, a first feedback unit 30, a second feedback unit 20 and a detection circuit 40. Herein, a second feedback module 20 is provided with a differentiator, the driving voltage source 18 is provided with an adder, and the output voltage at the output end of the comparator 16 and the voltage signal of a second feedback module 30 are input together into an input end of the adder.

Fig. 4 is an equivalent circuit of the circuit in fig. 2, if $U_{e2}$ is set to be the driving voltage of the driving voltage source 18, $U_{e3}$ is the output voltage of the comparator 16, $R$ is the resistance value of the sampling resistor 14, $L$ is the inductance of the coil 10, then:

$$U_{e2} = iR + Li^{'} \quad \text{Equation (2)}$$

at the same time

$$U_{e2} = U_{e3} + iR \quad \text{Equation (3)}$$

in Equation (2) and Equation (3), i represents the drive current, $i'$ represents the differential of i.

From Equation (2) and Equation (3) it can be deduced that:

$$i^{'} = U_{e3}/L \quad \text{Equation (4).}$$

Since $U_{e3}$ is the square wave voltage outputted by the comparator 16 in Equation (4) and the amplitude of $U_{e3}$ is a constant, when the magnetic core operates into the nonlinear region (saturation region), the inductance L of the magnetic ring will be reduced to a very small value rapidly, making $i'$ increase rapidly, the transition of the linear region and nonlinear region in the BH curve of the magnetic ring as shown in fig. 1 can be reflected by way of the monitoring of i by the second feedback unit 20, and when the control point corresponding to the reverse of the driving voltage is set in the nonlinear region, it can be very close to the intersection of the real linear region and nonlinear region.

The current i is related to the current to be measured in the conductor 11, since the amplitude of $U_{e3}$ in Equation (3) is a constant, the current i is only related to the amplitude of the output voltage of the driving voltage source 18, therefore, using such a current measurement method and a current measurement apparatus using this method, it would have a relatively wide range for current measurement.

When using a current measurement method and a current measurement apparatus using this method, since the reverse control point of the driving voltage is set in the nonlinear region close to the intersection of the real linear region and the nonlinear region of the magnetic core's BH curve, the saturation time of magnetic core is reduced, which can effectively reduce power consumption.

When using a current measurement method and a current measurement apparatus using this method, since the reverse control point of the driving voltage is set in the nonlinear region in the magnetic core's BH curve, automatic magnetic reset can be achieved.

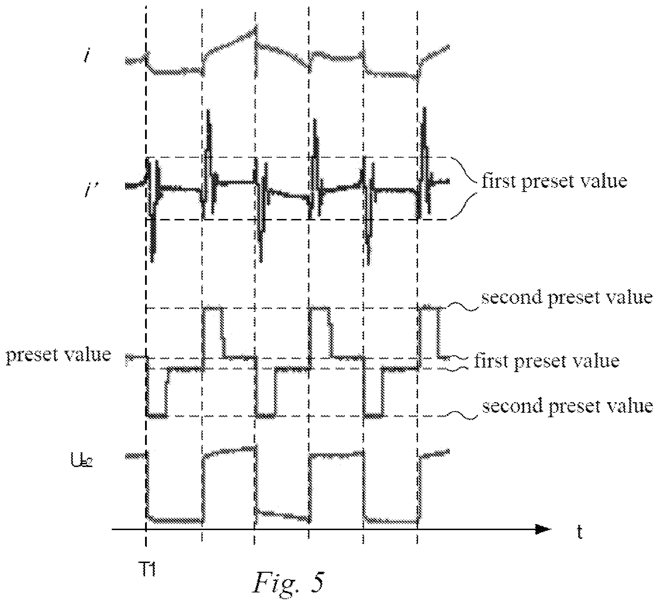

In the illustrative embodiment shown in fig. 2, two preset values can be set in the comparator 16: a first preset value and a second preset value, in which the second preset value is greater than the first preset value (referring to fig. 5), and when measuring the current, at the time the first preset value (forward or backward) is the same as the output value $i'$ of the second feedback unit 20, the output signal of the comparator 16 reverses the driving voltage $U_{e2}$ generated in the driving voltage source 18. In the embodiment shown in fig. 5, the second preset value is far greater than the first preset value, in the entire time domain, the output value $i'$ of the second feedback unit 20 cannot be the same as the second preset value, therefore, the second preset value can control the driving voltage source $U_{e2}$ to be in the remaining time domain other than the one with $i'$ being the same as the first preset value, and the driving voltage $U_{e2}$ cannot be

reversed. The sum of the voltage over the sampling resistor and the output voltage of the comparator is set to equal to the driving voltage $U_{e2}$.

Those skilled in the art would understand that the selection of the first preset value is related to the distance between the driving voltage reverse point and the turning point of the real linear region and the nonlinear region in the magnetic core's BH curve, which can be adjusted according to needs. Furthermore, taking the offset and polarity of the preset value into consideration, the first preset value can also be greater than, equal to or smaller than the second preset value.

In an illustrative embodiment shown in fig. 2, the output signal of the comparator 16 is a square wave voltage $U_{e3}$ with a fixed amplitude, the square wave voltage $U_{e3}$ can control the polarity of the driving voltage, and when the square wave voltage $U_{e3}$ is reversed, the driving voltage $U_{e2}$ is reversed at the same time.

In an illustrative embodiment, the driving voltage source 18 further comprises an adder (not shown in the figure), the output signal $U_{e3}$ of the comparator 16 and the voltage signal of the first feedback unit 30 are inputted together into an input end of the adder, and the sum of the output signal $U_{e3}$ of the comparator 16 and the voltage signal of the first feedback unit 30 is equal to the driving voltage $U_{e2}$ outputted by the driving voltage source 18.

Those skilled in the art would understand that the adder in the driving voltage source 18 can input the input signals of the first feedback unit and the second feedback unit into an input end of the adder and can also respectively input the input signals of the first feedback unit and the second feedback unit into the two input ends of the adder, then the accumulation of the output signals of the first feedback unit and the second feedback unit can be achieved by any of these two manners.

Furthermore, in an illustrative embodiment, a detection circuit 40 is also disposed in the current measurement apparatus, and this detection circuit acquires the voltage signal over the sampling resistor 14 to obtain a current signal measured thereby. This detection circuit 40 can further comprise a low-pass filter (not identified in the figure), such as a Butterworth filter.

When using a current measurement method and a current measurement apparatus using this method, the change of the coil inductance can be precisely reflected by a feedback signal, and when the current to be measured changes, the change of the reverse turning point of the magnetic core can be precisely reflected, therefore, it has very high current measurement accuracy.

**Claims**

1. An apparatus for current measurement, comprising:

    a magnetic ring (12), through which can pass at least one conductor for passing a current to be measured;
a coil (10) wound around said magnetic ring (12);
a sampling resistor (14), that produces a first feedback signal (111), which may be a voltage signal, wherein a first end of the sampling resistor (14) is electrically connected to a first end of said coil (10), so that the sampling resistor (14) is connected in series with said coil (10) and a second end of the sampling resistor (14) is connected to earth;
a driving voltage source (18), with an output end thereof being electrically connected to another end of said coil (10), the driving voltage source (18) having an adder;
a comparator (16), with an output end thereof being electrically connected to a first input end of said driving voltage source (18) being a first input end of the adder;
a first feedback unit (30), wherein an input end of said first feedback unit (30) is connected to the first end of said sampling resistor (14) for acquiring the first feedback signal (111) from said sampling resistor (14), wherein an output end of the first feedback unit (30) is electrically connected to another input end of said adder for providing the first feedback signal (111) to said driving voltage source (18);
a detection circuit (40) for acquiring the first feedback signal (111) from said sampling resistor (14) to obtain a current signal (i) measured thereby,
**characterized in that,** the apparatus further comprises a second feedback unit (20) having a differentiator, wherein an input of said second feedback unit (20) is connected to the first end of said sampling resistor (14) to acquire the first feedback signal (111) from said sampling resistor (14) to process the first feedback signal (111) by the differentiator and to generate a second feedback signal (112) via an output end of said second feedback unit,

wherein an output end of said second feedback unit (20) is connected to an input end of said comparator (16), wherein a first preset value and a second preset value are set in said comparator (16), the second preset value being greater than the first preset value, the first preset value controlling the output polarity of said driving voltage source (18), such that the reverse point of the output polarity of said driving voltage source (18) is set in a saturation region of said magnetic ring (12), and said second preset value is used to prevent said driving voltage ($U_{e2}$) from being reversed in the remaining time domain, except the one where the first preset value was used, and wherein the output voltage ($U_{e3}$) of said comparator (16) is a square wave voltage with a fixed amplitude.

**2.** A method for current measurement by means of an apparatus for current measurement as claimed in claim 1, comprising:

generating, by the driving voltage ($U_{e2}$), a drive current (i) in a current loop including the sampling resistor (14) and the coil (10) connected in series with the sampling resistor (14), the coil (10) wound around the magnetic core (12), through which can pass at least one conductor for passing a current to be measured;

acquiring the first feedback signal (111) generated over the sampling resistor (14) by said drive current (i);

**characterized in that,** processing the first feedback signal (111) by the differentiator to generate the second feedback signal (112); when the differential signal (i') of said drive current (i) is the same as the first preset value, said voltage signal output causes said driving voltage ($U_{e2}$) to reverse; and

in the remaining time domain except the one where the first preset value was used, the second preset value is used to prevent said driving voltage ($U_{e2}$) from being reversed in the remaining time domain, and

comparing the second feedback signal (112) with a preset value and outputting an output voltage signal ($U_{e3}$) according to the comparison result, the preset value comprising the first preset value and the second preset value, the second preset value being greater than the first preset value;

summing said first feedback signal (111) with said output voltage signal ($U_{e3}$) to obtain said driving voltage ($U_{e2}$); wherein a polarity of said driving voltage ($U_{e2}$) is controlled by said output voltage signal ($U_{e3}$), wherein the output voltage signal ($U_{e3}$) is a square wave voltage with a fixed amplitude.

**Patentansprüche**

**1.** Vorrichtung zur Strommessung, die aufweist:

einen Magnetring (12), durch den mindestens ein Leiter zum Führen eines zu messenden Stroms hindurchführen kann;

eine Spule (10), die um den Magnetring (12) gewickelt ist;

einen Abtastwiderstand (14), der ein erstes Rückkopplungssignal (111) ergibt, das ein Spannungssignal sein kann, wobei ein erstes Ende des Abtastwiderstands (14) mit einem ersten Ende der Spule (10) elektrisch verbunden ist, sodass der Abtastwiderstand (14) mit der Spule (10) in Reihe geschaltet ist, und ein zweites Ende des Abtastwiderstands (14) mit Masse verbunden ist;

eine Ansteuerspannungsquelle (18), wobei ein Ausgangsende davon mit einem anderen Ende der Spule (10) elektrisch verbunden ist, wobei die Ansteuerspannungsquelle (18) einen Addierer aufweist;

einen Komparator (16), wobei ein Ausgangsende davon mit einem ersten Eingangsende der Ansteuerspannungsquelle (18), das ein erstes Eingangsende des Addierers ist, elektrisch verbunden ist;

eine erste Rückkopplungseinheit (30), wobei ein Eingangsende der ersten Rückkopplungseinheit (30) mit dem ersten Ende des Abtastwiderstands (14) zum Erlangen des ersten Rückkopplungssignals (111) von dem Abtastwiderstand (14) verbunden ist, wobei ein Ausgangsende der ersten Rückkopplungseinheit (30) mit einem anderen Eingangsende des Addierers zum Bereitstellen des ersten Rückkopplungssignals (111) an die Ansteuerspannungsquelle (18) elektrisch verbunden ist;

eine Erfassungsschaltung (40) zum Erlangen des ersten Rückkopplungssignals (111) von dem Abtastwiderstand (14), um ein damit gemessenes Stromsignal (i) zu erhalten,

**dadurch gekennzeichnet, dass** die Vorrichtung ferner eine zweite Rückkopplungseinheit (20) mit einem Differenzierer aufweist, wobei ein Eingang der zweiten Rückkopplungseinheit (20) mit dem ersten Ende des Abtastwiderstands (14) verbunden ist, um das erste Rückkopplungssignal (111) von dem Abtastwiderstand (14) dafür zu erlangen, das erste Rückkopplungssignal (111) durch den Differenzierer zu verarbeiten und ein zweites Rückkopplungssignal (112) über ein Ausgangsende der zweiten Rückkopplungseinheit zu erzeugen,

wobei ein Ausgangsende der zweiten Rückkopplungseinheit (20) mit einem Eingangsende des Komparators (16) verbunden ist, wobei ein erster voreingestellter Wert und ein zweiter voreingestellter Wert in dem Komparator (16) eingestellt sind, der zweite voreingestellte Wert größer ist als der erste voreingestellte Wert, der erste voreingestellte Wert die Ausgangspolarität der Ansteuerspannungsquelle (18) derart steuert, dass der Umkehrpunkt der Ausgangspolarität der Ansteuerspannungsquelle (18) in einem Sättigungsbereich des Magnetrings (12) eingestellt ist, und der zweite voreingestellte Wert dafür verwendet wird, zu verhindern, dass die Ansteuerspannung ($U_{e2}$) in dem verbleibenden Zeitbereich umgekehrt wird, abgesehen davon, wenn der erste voreingestellte Wert verwendet wurde, und

wobei die Ausgangsspannung ($U_{e3}$) des Kom-

parators (16) eine Rechteckspannung mit fester Amplitude ist.

2. Verfahren zur Strommessung mittels einer Vorrichtung zur Strommessung nach Anspruch 1, das umfasst:

Erzeugen eines Ansteuerstroms (i) in einer Stromschleife, die den Abtastwiderstand (14) und die Spule (10), die mit dem Abtastwiderstand (14) in Reihe geschaltet ist, enthält, durch die Ansteuerspannung ($U_{e2}$), wobei die Spule (10) um den Magnetring (12) gewickelt ist, durch den mindestens ein Leiter zum Führen eines zu messenden Stroms hindurchführen kann; Erlangen des ersten Rückkopplungssignals (111), das über den Abtastwiderstand (14) durch den Ansteuerstrom (i) erzeugt wird; **dadurch gekennzeichnet, dass** ein Verarbeiten des ersten Rückkopplungssignals (111) durch den Differenzierer erfolgt, um das zweite Rückkopplungssignal (112) zu erzeugen; wenn das Differentialsignal (i') des Ansteuerstroms (i) das Gleiche ist wie der erste voreingestellte Wert, die Spannungssignalausgabe bewirkt, dass die Ansteuerspannung ($U_{e2}$) umkehrt; und in dem verbleibenden Zeitbereich, abgesehen davon, wenn der erste voreingestellte Wert verwendet wurde, der zweite voreingestellte Wert dafür verwendet wird, zu verhindern, dass die Ansteuerspannung ($U_{e2}$) in dem verbleibenden Zeitbereich umgekehrt wird, und Vergleichen des zweiten Rückkopplungssignals (112) mit einem voreingestellten Wert und Ausgeben eines Ausgangsspannungssignals ($U_{e3}$) gemäß dem Vergleichsergebnis, wobei der voreingestellte Wert den ersten voreingestellten Wert und den zweiten voreingestellten Wert umfasst, wobei der zweite voreingestellte Wert größer ist als der erste voreingestellte Wert; Summieren des ersten Rückkopplungssignals (111) mit dem Ausgangsspannungssignal ($U_{e3}$), um die Ansteuerspannung ($U_{e2}$) zu erhalten; wobei eine Polarität der Ansteuerspannung ($U_{e2}$) durch das Ausgangsspannungssignal ($U_{e3}$) gesteuert wird, wobei das Ausgangsspannungssignal ($U_{e3}$) eine Rechteckspannung mit fester Amplitude ist.

**Revendications**

1. Appareil de mesure de courant, comprenant :

un anneau magnétique (12) au travers duquel peut passer au moins un conducteur destiné à conduire un courant à mesurer, une bobine (10) enroulée autour dudit anneau magnétique (12), une résistance d'échantillonnage (14) qui génère un premier signal de rétroaction (111) qui peut être un signal de tension dans lequel une première extrémité de la résistance d'échantillonnage (14) est reliée électriquement à une première extrémité de ladite bobine (10) de sorte à ce que la résistance d'échantillonnage (14) soit reliée en série avec ladite bobine (10) et où la seconde extrémité de la résistance d'échantillonnage (14) est reliée à la terre, une source de tension d'attaque (18) dont une extrémité de sortie est reliée électriquement à une autre extrémité de ladite bobine (10), la source de tension d'attaque (18) comportant un additionneur, un comparateur (16) dont une extrémité de sortie est reliée électriquement à une première entrée de ladite source de tension d'attaque (18) en tant que première extrémité d'entrée de l'additionneur, une première unité de rétroaction (30) où une extrémité d'entrée de ladite première unité de rétroaction (30) est reliée à la première extrémité de ladite résistance d'échantillonnage (14) afin d'acquérir le premier signal de rétroaction (111) provenant de ladite résistance d'échantillonnage (14), une extrémité de sortie de la première unité de rétroaction (30) étant reliée électriquement à une autre extrémité d'entrée dudit additionneur afin de délivrer le premier signal de rétroaction (111) à ladite source de tension d'attaque (18), un circuit de détection (40) destiné à acquérir le premier signal de rétroaction (111) provenant de ladite résistance d'échantillonnage (14) pour récupérer un signal de courant (i) mesuré ainsi, **caractérisé en ce que** l'appareil comprend en outre une seconde unité de rétroaction (20) comportant un différentiateur, une entrée de ladite seconde unité de rétroaction (20) étant reliée à la première extrémité de ladite résistance d'échantillonnage (14) afin d'acquérir le premier signal de rétroaction (111) provenant de ladite résistance d'échantillonnage (14) pour traiter le premier signal de rétroaction (111) par le différentiateur et pour générer un second signal de rétroaction (112) par l'intermédiaire d'une extrémité de sortie de ladite seconde unité de rétroaction, dans lequel une extrémité de sortie de ladite seconde unité de rétroaction (20) est reliée à une extrémité d'entrée dudit comparateur (16), une première valeur préréglée et une seconde valeur préréglée étant établies dans ledit comparateur (16), la seconde valeur préréglée étant supérieure à la première valeur préréglée, la première valeur préréglée commandant la polarité de sortie de ladite source de tension d'attaque (18) de sorte à ce que le point d'inversion de la polarité de sortie de ladite source de tension d'attaque (18) soit réglé dans la zone de saturation dudit anneau magnétique (12) ; et ladite seconde valeur préréglée étant utilisée pour empêcher l'inversion de ladite tension d'attaque ($U_{e2}$) dans le domaine de temps restant à l'exception de celui dans lequel la première valeur préréglée a été utilisée, et

dans lequel la tension de sortie ($U_{e3}$) dudit comparateur (16) est une tension carrée présentant une amplitude fixe.

2.  Procédé de mesure de courant au moyen d'un appareil de mesure de courant tel que soutenu dans la revendication 1, comprenant :

la génération, grâce à la tension d'attaque ($U_{e2}$), d'un courant d'attaque (i) dans une boucle de courant incluant la résistance d'échantillonnage (14) et la bobine (10) reliée en série avec la résistance d'échantillonnage (14), la bobine (10) étant enroulée autour du noyau magnétique (12) au travers duquel peut passer au moins un conducteur destiné à conduire un courant à mesurer,

l'acquisition du premier signal de rétroaction (111) généré sur la résistance d'échantillonnage (14) par ledit courant d'attaque (i), **caractérisé par** le traitement du premier signal de rétroaction (111) par le différentiateur pour générer le second signal de rétroaction (112) ; lorsque le signal différentiel (i') dudit courant d'attaque (i) est identique à la première valeur préréglée, ledit signal de tension en sortie amène l'inversion de ladite tension d'attaque ($U_{e2}$), et

dans le domaine du temps restant, à l'exception de celui dans lequel la première valeur préréglée a été utilisée, la seconde valeur préréglée est utilisée pour empêcher l'inversion de ladite tension d'attaque ($U_{e2}$) dans le domaine de temps restant, et

la comparaison du second signal de rétroaction (112) à une valeur préréglée et la délivrance d'un signal de tension de sortie ($U_{e3}$) en fonction du résultat de comparaison, la valeur préréglée étant constituée de la première valeur préréglée et de la seconde valeur préréglée, la seconde valeur préréglée étant supérieure à la première valeur préréglée,

la sommation dudit premier signal de rétroaction (111) avec ledit signal de tension de sortie ($U_{e3}$) pour obtenir ladite tension d'attaque ($U_{e2}$) ; dans lequel la polarité de ladite tension d'attaque ($U_{e2}$) est commandée par ledit signal de tension de sortie ($U_{e3}$), ledit signal de tension de sortie

($U_{e3}$) étant une tension carrée présentant une amplitude fixe.

*Fig. 1*

*Fig. 2*

*Fig. 3*

*Fig. 4*

*Fig. 5*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6984979 B1
- US 20090315536 A1
- EP 1212821 A
- EP 1610133 A